# EUROPEAN PATENT APPLICATION

(11) **EP 4 711 508 A1**
(43) Date of publication of application: **18.03.2026**
(21) Application number: 25201174.7
(22) Date of filing: 09.09.2025
(51) Int. Cl.: C30B 25/00, C30B 23/00, H10P 14/00

(54) **SIC EPITAXIAL WAFER**

(30) Priority: 12.09.2024 JP 2024158015
(71) Applicant: Resonac Corporation, Tokyo 105-7325 (JP)
(72) Inventor: SHIONO, Tsubasa, Tokyo, 105-7325 (JP); UMETA, Yoshikazu, Tokyo, 105-7325 (JP); OHUCHI, Marie, Tokyo, 105-7325 (JP); ITO, Masato, Tokyo, 105-7325 (JP); KINDAICHI, Rimpei, Tokyo, 105-7325 (JP)
(74) Representative: Strehl & Partner mbB

(57) **Abstract**

The SiC epitaxial wafer has a notch. The notch has a first side and a second side that connect the innermost point of the notch and an outer circumference of the wafer. The first side is in a [-1-120] direction from the innermost point, and the second side is in a [11-20] direction from the innermost point. A position of 0.5 mm from a middle point of the first side in a [-1100] direction is set as a first measurement point, and a position of 0.5 mm from a middle point of the second side in the [-1100] direction is set as a second measurement point. A film thickness variation at the first measurement point and the second measurement point of the SiC epitaxial layer of the SiC epitaxial wafer is less than 10%.

## Description

### CROSS-REFERENCE TO RELATED APPLICATION

Priority is claimed on Japanese Patent Application No. 2024-158015, filed September 12, 2024, the content of which is incorporated herein by reference.

### BACKGROUND

### Field of the Invention

The present disclosure relates to a SiC epitaxial wafer.

### Description of Related Art

Silicon carbide (SiC) has a dielectric breakdown field slightly greater and a band gap three times larger than those of silicon (Si). In addition, silicon carbide (SiC) has a thermal conductivity about three times higher than that of silicon (Si). For this reason, silicon carbide (SiC) is expected to be used in power devices, high frequency devices, or the like. In addition, silicon carbide (SiC)-based devices can operate in temperature ranges as high as 150°C or higher. The SiC devices are obtained by forming devices on a SiC epitaxial layer of a SiC epitaxial wafer and then cutting the SiC epitaxial wafer into chips.

The SiC epitaxial wafer is obtained by laminating the SiC epitaxial layer on a surface of a SiC substrate. Hereinafter, a substrate before lamination of the SiC epitaxial layer is referred to as a SiC substrate, and the substrate after lamination of the SiC epitaxial layer is referred to as a SiC epitaxial wafer. The SiC substrate is fabricated by cutting it from a SiC ingot.

For example, Patent Documents 1 to 3 disclose a method for manufacturing a SiC epitaxial wafer by epitaxially growing a SiC epitaxial layer on a SiC substrate. In addition, Patent Documents 1 to 3 disclose supplying gas to a back surface of the SiC substrate in order to prevent deposits from adhering to the back surface of the SiC substrate.

### [Patent Documents]

[Patent Document 1] Japanese Unexamined Patent Application, First Publication No. 2022-78450
[Patent Document 2] Japanese Unexamined Patent Application, First Publication No. 2022-66742
[Patent Document 3] Japanese Unexamined Patent Application, First Publication No. 2019-7045

### SUMMARY

The SiC substrate and the SiC epitaxial wafer may have a notch in order to determine a orientation of a crystal axis. The notch is a cutout portion formed in the SiC substrate and the SiC epitaxial wafer. By reading a position of the notch when the SiC devices are fabricated using a laser or the like, an orientation of the SiC epitaxial wafer is adjusted such that a predetermined crystal axis of the SiC epitaxial wafer is oriented in a predetermined direction.

Variations in thickness or shape near the notch can cause failure of the laser reading of the notch position.

In consideration of the above-mentioned problems, the present disclosure is directed to providing a SiC epitaxial wafer with small film thickness variation in a SiC epitaxial layer near a notch.
(1) A SiC epitaxial wafer according to a first aspect has a SiC substrate and a SiC epitaxial layer. The SiC epitaxial wafer according to the first aspect has a notch formed by cutting out a part of the wafer inward from an outer circumference when seen in a plan view in a lamination direction. The notch has a first side and a second side that connect the innermost point of the notch and an outer circumference of the wafer. The first side is in a [-1-120] direction from the innermost point. The second side is in a [11-20] direction from the innermost point. A position of 0.5 mm from a first point that is a middle point of the first side in a [-1100] direction is set as a first measurement point, and a position of 0.5 mm from a second point that is a middle point of the second side in a [-1100] direction is set as a second measurement point. A film thickness variation between a first film thickness of the SiC epitaxial layer at the first measurement point and a second film thickness of the SiC epitaxial layer at the second measurement point is less than 10%. The film thickness variation is calculated by dividing an absolute value of a difference between the first film thickness and the second film thickness by twice an average film thickness of the first film thickness and the second film thickness.
(2) The SiC epitaxial wafer according to the above-mentioned aspect may satisfy (|L(x)-R(x)|)/(2×Ave (L(x), R(x)))× 100 < 10% in x ≤ 5. L(x) is a film thickness of the SiC epitaxial layer at a position of x mm from the first point in the [-1100] direction. R(x) is a film thickness of the SiC epitaxial layer at a position of x mm from the second point in the [-1100] direction. Ave (L(x), R(x)) is an average value of L(x) and R(x).
(3) The SiC epitaxial wafer according to the above-mentioned aspect may have a diameter of 145 mm or more.
(4) The SiC epitaxial wafer according to the above-mentioned aspect may have a diameter of 195 mm or more.
(5) In the SiC epitaxial wafer according to the above-mentioned aspect, the SiC epitaxial layer may have a variation in film thickness in a radial direction of 5% or less. The variation in film thickness in the radial direction is calculated by dividing a difference between a maximum value and a minimum value of the film thickness of the SiC epitaxial layer measured along a straight line that passes through a center of the SiC epitaxial layer and extends in the <11-20> direction by twice the average value.
(6) In the SiC epitaxial wafer according to the above-mentioned aspect, the SiC epitaxial layer may have a variation in film thickness in a circumferential direction of 5% or less. The variation in film thickness in the circumferential direction is calculated by dividing a difference between a maximum value and a minimum value of the film thickness of the SiC epitaxial layer measured at a total of four points of two points of half a radius from a center of the SiC epitaxial layer in the <11-20> direction and two points of half a radius from the center of the SiC epitaxial layer in the <-1-100> direction by twice the average value.

The SiC epitaxial wafer according to the aspect has a small film thickness variation in the SiC epitaxial layer near the notch.

### BRIEF DESCRIPTION OF THE DRAWINGS

FIG. 1 is a cross-sectional view of a SiC epitaxial wafer according to an embodiment.
FIG. 2 is a plan view of the SiC epitaxial wafer according to the embodiment.
FIG. 3 is an enlarged view near the notch of the SiC epitaxial wafer according to the embodiment.
FIG. 4 is a cross-sectional view of an apparatus for manufacturing the SiC epitaxial wafer according to the embodiment.
FIG. 5 is a cross-sectional view of a SiC substrate, which is placed on a susceptor.
FIG. 6 is a plan view showing a positional relationship between a slit of the susceptor and a notch.
FIG. 7 shows simulation results of Comparative Example 1.
FIG. 8 shows a supply amount of a source gas along each of a reference line, a first measurement line, and a second measurement line in the simulation results of Comparative Example 1.
FIG. 9 is a view showing a positional relationship of slits in Example 1, and Comparative Examples 2 to 4.
FIG. 10 shows a supply amount of a source gas along the first measurement line in the simulation results of Example 1, and Comparative Examples 1 to 4.
FIG. 11 shows a supply amount of a source gas along the second measurement line in the simulation results of Example 1, and Comparative Examples 1 to 4.

### DETAILED DESCRIPTION

Hereinafter, a SiC epitaxial wafer or the like according to an embodiment will be described in detail with reference to the accompanying drawings as appropriate. The drawings used in the following description may show enlarged portions of the features of this embodiment for the sake of clarity, and dimensional ratios of each component may differ from the actual ones. Materials, dimensions, etc. exemplified in the following description are merely examples, the present invention is not limited to them, and it is possible to carry out appropriate modifications without departing from the spirit of the invention.

In the specification, an individual orientation is indicated by [], and a collective orientation is indicated by <>. For negative index, a "-" (bar) is placed above the number in crystallography, but in this specification, a minus sign is placed before the number.

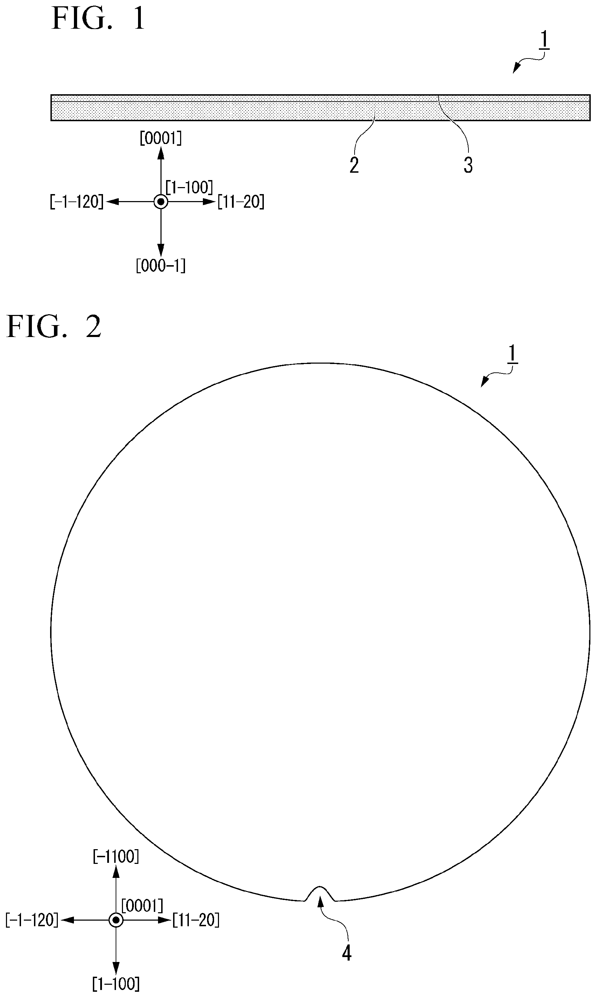

FIG. 1 is a cross-sectional view of a SiC epitaxial wafer 1 according to the embodiment. The SiC epitaxial wafer 1 includes a SiC substrate 2 and a SiC epitaxial layer 3. The SiC epitaxial wafer 1 has a substantially circular shape when seen in a plan view.

A diameter of the SiC epitaxial wafer 1 is, for example, 6 inches or more, preferably 8 inches or more, more preferably 10 inches or more, further preferably 12 inches or more.

The diameter of the SiC epitaxial wafer 1 is, for example, 145 mm or more, preferably 149 mm or more. The diameter of the SiC epitaxial wafer 1 is for example, 155 mm or less, preferably 151 mm or less. The diameter of the SiC epitaxial wafer 1 may be, for example, 195 mm or more, preferably 199 mm or more. The diameter of the SiC epitaxial wafer 1 may be, for example, 205 mm or less, preferably 201 mm or less. The diameter of the SiC epitaxial wafer 1 may be, for example, 245 mm or more, preferably 249 mm or more. The diameter of the SiC epitaxial wafer 1 may be, for example, 255 mm or less, preferably 251 mm or less. The diameter of the SiC epitaxial wafer 1 may be, for example, 295 mm or more, preferably 299 mm or more. The diameter of the SiC epitaxial wafer 1 may be, for example, 305 mm or less, preferably 301 mm or less.

The SiC substrate 2 is made of, for example, n type SiC. A conductivity type of the SiC substrate 2 may be p type or semi-insulating property. A poly type of the SiC substrate 2 is not particularly limited and may be any of 2H, 3C, 4H and 6H. The SiC substrate 2 is, for example, 4H-SiC. The diameter of the SiC substrate 2 is equal to that of the SiC epitaxial wafer 1.

The SiC epitaxial layer 3 is laminated on one surface of the SiC substrate 2. The SiC epitaxial layer 3 is made of SiC.

FIG. 2 is a plan view of the SiC epitaxial wafer 1 according to the embodiment. In FIG. 2, the Si surface is positioned as an upper surface. The upper surface of the SiC epitaxial wafer 1 may be a (0001) surface or may be a surface inclined by an offset angle from the (0001) surface. The offset angle is, for example, 3.5° or more and 4.5° or less, preferably 4°. The offset angle may be, for example, 0° or more and 10° or less, may be greater than 0° and 10° or less, may be 7.5° or more and 8.5° or less, or may be 8°.

The SiC epitaxial wafer 1 has a notch 4 in order to determine a direction of a crystal axis when seen in a lamination direction. Here, the lamination direction is a lamination direction of the SiC epitaxial layer 3. The notch 4 is a groove obtained by cutting out a part of the wafer inward from an outer circumference of the SiC epitaxial wafer 1. The notch 4 is located in, for example, a [1-100] direction from a center of the SiC epitaxial wafer 1.

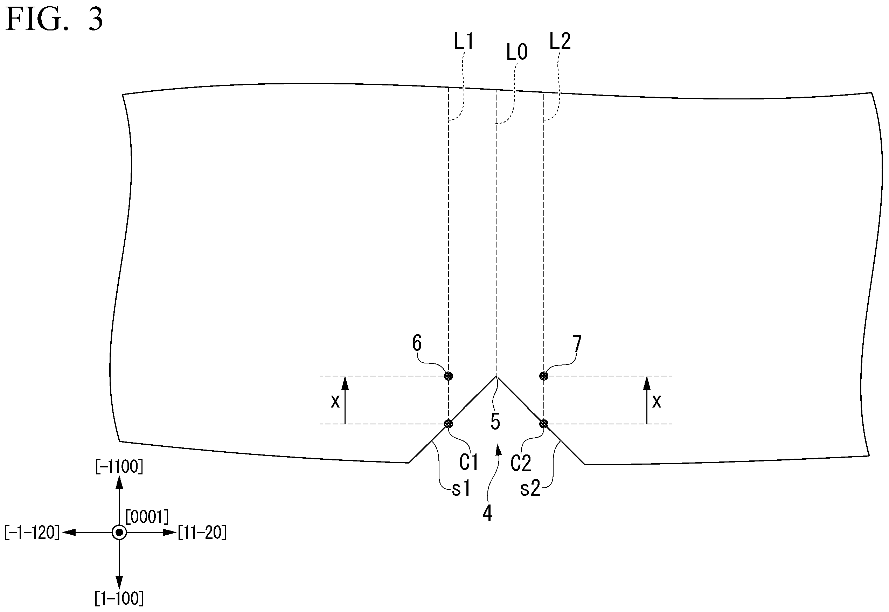

FIG. 3 is an enlarged view near the notch 4 of the SiC epitaxial wafer 1 according to the embodiment. The notch 4 is, for example, a V-type groove. The notch 4 exists across the SiC substrate 2 and the SiC epitaxial layer 3. A depth of the groove of the notch 4 may be, for example, 2 mm, or may be 1 mm. The depth of the groove of the notch 4 is the shortest distance between the innermost point 5 of the notch 4 and a virtual circle along an outer circumference of the SiC epitaxial wafer 1, and a distance of a perpendicular line drawn from the innermost point 5 toward the virtual circle in the [1-100] direction.

The notch 4 has a first side s1 and a second side s2. Each of the first side s1 and the second side s2 is a side that connects the innermost point 5 of the notch 4 and the outer circumference of the SiC epitaxial wafer 1. The first side s1 and the second side s2 may be straight lines or curves. The first side s1 is located in a [-1-120] direction from the innermost point 5, and the second side s2 is located in a [11-20] direction from the innermost point 5. When viewed from the upper surface of the SiC epitaxial wafer 1 with the notch 4 positioned in front, the first side s1 is located to the left of the innermost point 5, and the second side s2 is located to the right of the innermost point 5. Hereinafter, with respect to a reference line L0, which passes through the innermost point 5 and extends in the <1-100> direction, the [-1-120] direction side is sometimes referred to as the left side, and the [11-20] direction side is sometimes referred to as the right side.

In the SiC epitaxial wafer 1 according to the embodiment, a film thickness variation between a first film thickness of the SiC epitaxial layer 3 at a first measurement point 6 and a second film thickness of the SiC epitaxial layer 3 at a second measurement point 7 is less than 10%. The film thickness variation of the SiC epitaxial layer 3 is preferably 5% or less, preferably 2% or less, preferably 1.5% or less, more preferably 1% or less, further preferably 0.5% or less. Here, the film thickness variation of the SiC epitaxial layer 3 is calculated by dividing an absolute value of a difference between the first film thickness and the second film thickness by twice an average film thickness of the first film thickness and the second film thickness.

The first measurement point 6 is a measurement point located 0.5 mm shifted along a first measurement line L1 in the [-1100] direction from a first point C1, which is a middle point of the first side s1. The first measurement line L1 is a virtual line that passes through the first point C1 and extends in the <1-100> direction. The second measurement point 7 is a measurement point located 0.5 mm shifted along a second measurement line L2 in the [-1100] direction from a second point C2, which is the middle point of the second side s2. The second measurement line L2 is a virtual line that passes through the second point C2 and extends in the <1-100> direction.

The SiC epitaxial wafer 1 according to the embodiment has small film thickness variation of the SiC epitaxial layer 3 at the first measurement point 6 and the second measurement point 7, and has high lateral symmetry with respect to the reference line L0 which passes through the innermost point 5 and extends in the <1-100> direction.

The SiC epitaxial wafer 1 according to the embodiment satisfies a relationship of |(L(x)-R(x))|/(2×Ave (L(x), R(x))) < 10%, preferably in 0 ≤ x ≤ 3, more preferably in x ≤ 5. In 0 ≤ x ≤ 3, |(L(x)-R(x))|/(2×Ave (L(x), R(x)) is preferably 5% or less, preferably 2% or less, preferably 1.5% or less, more preferably 1% or less, further preferably 0.5% or less. In addition, in x ≤ 5, |(L(x)-R(x))|/(2×Ave (L(x), R(x))) is, preferably 5% or less, preferably 2% or less, preferably 1.5% or less, more preferably 1% or less, further preferably 0.5% or less.

L(x) is a film thickness of the SiC epitaxial layer 3 at the measurement point located at a position of x mm from the first point C1 in the [-1100] direction. L(0.5) corresponds to a film thickness of the SiC epitaxial layer 3 at the first measurement point 6. R(x) is a film thickness of the SiC epitaxial layer 3 at a measurement point located at a position of x mm from the second point C2 in the [-1100] direction. R(0.5) corresponds to a film thickness of the SiC epitaxial layer 3 at the second measurement point 7. Ave (L(x), R(x)) is an average value of L(x) and R(x).

Here, the film thickness of the SiC epitaxial layer 3 near the notch 4 is measured using microscopic FTIR. For microscopic FTIR, for example, Vertex HYPERION manufactured by Bruker Corporation can be used. A spot size of FTIR is 300 µm×300 µm. Since light scattering is likely to occur near the notch 4, measurement can be performed using a Fourier transform infrared spectrophotometer (FTIR), but the film thickness of the SiC epitaxial layer 3 can be measured more accurately by using a microscopic FTIR.

An average film thickness of the SiC epitaxial layer 3 is, for example, 3 µm or more, preferably 5 µm or more, further preferably 10 µm or more, further preferably 15 µm or more. The average film thickness of the SiC epitaxial layer 3 may be, for example, 200 µm or less. The average film thickness of the SiC epitaxial layer 3 is an average value of the film thicknesses of the SiC epitaxial layer 3 measured at different points of the SiC epitaxial layer 3 in the radial direction. The average film thickness in the radial direction is measured along a straight line extending in, for example, a <11-20> direction. A position of the measurement point will be described below.

The variation in film thickness of the SiC epitaxial layer 3 in the radial direction is, for example, 5% or less, preferably 4% or less, more preferably 3% or less, further preferably 2% or less, particularly preferably 1% or less.

The variation in film thickness in the radial direction is calculated by dividing a difference between the maximum value and the minimum value of the film thickness of the SiC epitaxial layer 3 measured along the straight line that passes through the center of the SiC epitaxial layer 3 and extends in the <11-20> direction by twice the average value. The film thickness of the SiC epitaxial layer 3 is calculated from optical interference analysis by the Fourier transform infrared spectrophotometer (FTIR).

Measurement of the film thickness of the SiC epitaxial layer 3 may be performed at 10 mm intervals, 15 mm intervals, 20 mm intervals, 25 mm intervals, or 30 mm intervals. Whether measuring the average film thickness of the SiC epitaxial layer 3 or determining the variation in film thickness of the SiC epitaxial layer 3 in the radial direction, the film thickness of the SiC epitaxial layer 3 is measured at the same measurement position.

For example, when the diameter of the SiC epitaxial wafer 1 is 150 mm (6 inches), the film thickness of the SiC epitaxial layer 3 is measured at each position of a center, and ±15 mm, ±30 mm, ±45 mm, ±60 mm and ±70 mm from the center along the straight line with reference to the center extending in the <11-20> direction. Further, the [11-20] direction or the [-1100] direction is expressed as "+". Using each of the film thicknesses at these measurement points, the film thickness variation of the SiC epitaxial layer 3 in the radial direction and the average film thickness of the SiC epitaxial layer 3 are obtained.

For example, when the diameter of the SiC epitaxial wafer 1 is 200 mm (8 inches), the film thickness of the SiC epitaxial layer 3 is measured at each position at a center and ±20 mm, ±40 mm, ±60 mm, ±80 mm and ±95 mm from the center along the straight line extending in the <11-20> direction with reference to the center. Using each of the film thicknesses at these measurement points, the film thickness variation of the SiC epitaxial layer 3 in the radial direction and the average film thickness of the SiC epitaxial layer 3 are obtained.

In addition, for example, when the diameter of the SiC epitaxial wafer 1 is 250 mm (10 inches), the film thickness of the SiC epitaxial layer 3 is measured at each position of a center and ±25 mm, ±50 mm, ±75 mm, ±100 mm and ±120 mm from the center along the straight line extending in the <11-20> direction with reference to the center. Using each of the film thicknesses at these measurement points, the film thickness variation of the SiC epitaxial layer 3 in the radial direction and the average film thickness of the SiC epitaxial layer 3 are obtained.

In addition, for example, when the diameter of the SiC epitaxial wafer 1 is 300 mm (12 inches), the carrier concentration is measured at each position of a center and ±30 mm, ±60 mm, ±90 mm, ±120 mm and ±145 mm from the center along the straight line straight in the <11-20> direction with reference to the center. Using each of the film thicknesses at these measurement points, the film thickness variation of the SiC epitaxial layer 3 in the radial direction and the average film thickness of the SiC epitaxial layer 3 are obtained.

The variation in film thickness of the SiC epitaxial layer 3 in the circumferential direction is, for example, 5% or less, preferably 4% or less, more preferably 3% or less, further preferably 2% or less, particularly preferably 1% or less.

The variation in film thickness in the circumferential direction is calculated by dividing the difference between the maximum value and the minimum value of the film thickness of the SiC epitaxial layer 3 measured at four points at symmetrical positions with reference to the center of the SiC epitaxial layer 3 when seen in a plan view in the lamination direction by twice the average value. The four measurement points are, for example, two points located half a radius from the center of the SiC epitaxial layer 3 in the <11-20> direction, and two points located half a radius from the center of the SiC epitaxial layer 3 in the <-1-100> direction. The film thickness of the SiC epitaxial layer 3 is obtained from optical interference analysis by the Fourier transform infrared spectrophotometer (FTIR).

In addition, the variation in carrier concentration of the SiC epitaxial layer 3 in the radial direction is preferably 20% or less, more preferably 15% or less further preferably 12% or less, further preferably 10% or less, particularly preferably 5% or less, more particularly preferably 2% or less. The measurement point where the variation in carrier concentration in the radial direction is measured is the same as the measurement point where the variation in film thickness of the SiC epitaxial layer 3 in the radial direction is measured. The variation in carrier concentration in the radial direction is calculated by dividing the difference between the maximum value and the minimum value of the carrier concentration of the SiC epitaxial layer 3 measured along the straight line that passes through the center of the SiC epitaxial layer 3 and extending in the <11-20> direction by twice the average value.

In addition, the variation in carrier concentration of the SiC epitaxial layer 3 in the circumferential direction is, preferably 20% or less, more preferably 15% or less, further preferably 12% or less, further preferably 10% or less, particularly preferably 5% or less, more particularly preferably 2% or less. The measurement point where the variation in carrier concentration in the circumferential direction is measured is the same as the measurement point where the variation in film thickness of the SiC epitaxial layer 3 in the circumferential direction is measured. A depth position where the variation in carrier concentration is measured is substantially the same as each of the measurement points. Here, for example, an absolute value of the difference between the maximum value and the minimum value at the depth positions of these measurement points is substantially equal when it falls within a range of ±5% of the thickness at the center of the SiC epitaxial layer 3. The variation in carrier concentration in the circumferential direction is calculated by dividing the difference between the maximum value and the minimum value of the carrier concentration of the SiC epitaxial layer 3 measured at four points located at symmetrical positions with reference to the center of the SiC epitaxial layer 3 when seen in a plan view in the lamination direction by twice the average value.

Here, the carrier concentration is an effective carrier concentration. The effective carrier concentration is an absolute value of a difference between a donor concentration and an acceptor concentration. The carrier concentration of the SiC epitaxial layer 3 can be measured by, for example, a mercury probe (Hg-CV) method, or a secondary ion mass spectrometry (SIMS) method. The Hg-CV method measures the difference between the donor concentration and the acceptor concentration as the effective carrier concentration. The secondary ion mass spectrometry (SIMS) method is a method of scraping a layer in the thickness direction and performing mass spectrometry of the secondary ions that emerge. The doping concentration can be measured from the mass spectrometry. The secondary ion mass spectrometry (SIMS) method can measure the actual values of the donor concentration and the acceptor concentration, and the effective carrier concentration can be determined by calculating the difference between these values at the same depth position (measurement prescribed position).

Next, a method of manufacturing the SiC epitaxial wafer 1 according to the embodiment will be described.

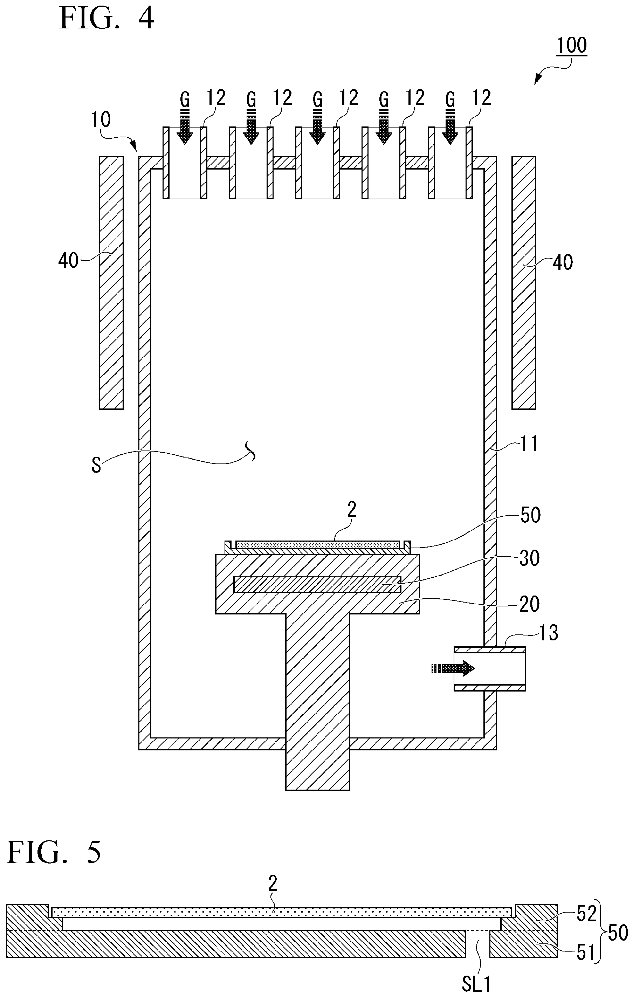

FIG. 4 is a cross-sectional schematic view of an example of a film forming apparatus for a SiC epitaxial wafer according to the embodiment. A film forming apparatus 100 has for example, a chamber 10, a support body 20, a lower heater 30, and an upper heater 40. The SiC substrate 2 is placed on a susceptor 50, and transported into the film forming apparatus 100.

The support body 20 supports the susceptor 50. The SiC substrate 2 is disposed on the support body 20, for example, while being placed on the susceptor 50. The support body 20 is rotatable about, for example, an axial center. As the support body 20 rotates, the susceptor 50 and the SiC substrate 2 are rotated together with the support body 20.

The support body 20 is configured to supply a purge gas toward a back surface of the susceptor 50. The support body 20 has, for example, a supply port for a purge gas toward the back surface of the susceptor 50 and a gas flow path that carries the purge gas to the supply port. The purge gas is an inert gas, for example, nitrogen, argon, or the like.

The lower heater 30 is disposed in, for example, the support body 20 and heats the SiC substrate 2. The upper heater 40 heats an upper portion of the chamber 10.

The chamber 10 has, for example, a main body 11, a gas supply port 12, and a gas discharge port 13. The main body 11 surrounds a film forming space S. The gas supply port 12 is an entrance through which a gas G is supplied into the film forming space S. The plurality of gas supply ports 12 are provided, for example, above the placing surface of the SiC substrate 2. The film forming apparatus in which the gas supply port 12 is located above the placing surface of the SiC substrate 2 is referred to as a vertical furnace. The gas discharge port 13 is an outlet through which the gas G and other gases accumulated in the film forming space S are discharged. The gas discharge port 13 is located below, for example, the placing surface of the SiC substrate 2.

The gas G is, for example, a source gas, a carrier gas, a dopant gas, and an etching gas. The source gas contains a Si-based source gas, and a C-based source gas.

The Si-based source gas is a source gas containing Si in molecule. The Si-based source gas is, for example, silane (SiH₄), dichloro-silane (SiH₂Cl₂), trichloro-silane (SiHCl₃), tetrachloro-silane (SiCl₄), or the like. The Si-based source gas preferably contains at least one selected from the group consisting of, for example, SiH₃Cl, SiH₂Cl₂ and SiHCl₃.

The C-based source gas is a source gas containing C in molecule. The C-based source gas is, for example, propane (C₃H₈), ethylene (C₂H₄), or the like. The C-based source gas preferably contains at least one selected from the group consisting of, for example, CH₄, C₂H₆ and C₃H₈ .

The dopant gas is a gas that contains a carrier element. The dopant gas is, for example, nitrogen (N₂).

The carrier gas is a gas that transports the source gas to the SiC substrate 2 and a gas inert to SiC. The carrier gas preferably contains, for example, Ar.

The etching gas is a gas that reacts with SiC at high temperatures and etches it. The etching gas is preferably, for example, hydrogen chloride (HCl).

The susceptor 50 supports the SiC substrate 2. FIG. 5 is a cross-sectional view of the SiC substrate 2 placed on the susceptor 50. The susceptor 50 has a main body 51, and a frame 52 protruding from the main body 51. The frame 52 prevents the rotating SiC substrate 2 from flying outward during film formation.

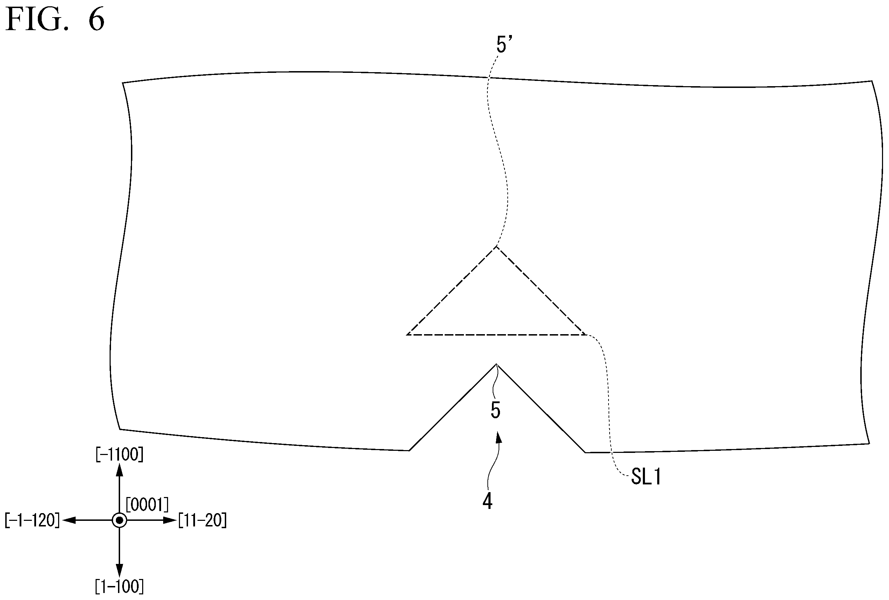

The main body 51 has a slit SL1. The purge gas is supplied toward the back surface of the SiC substrate 2 via the slit SL1. FIG. 6 is a plan view showing a positional relationship between the slit SL1 and the notch 4. Since the susceptor 50 and the SiC substrate 2 rotate together, the positional relationship between the slit SL1 and the notch 4 does not change even during film formation.

The shape of the slit SL1 is substantially the same as that of the notch 4. The slit SL1 is formed in the [-1100] direction with respect to the notch 4. The slit SL1 is located at a position that does not overlap with the notch 4. For example, a distance between the innermost point 5 of the notch 4 and the innermost point 5' of the slit SL1 is 2 mm.

The SiC epitaxial wafer 1 according to this embodiment can be obtained, for example, by forming the SiC epitaxial layer 3 on the SiC substrate 2 using the film forming apparatus for a SiC epitaxial wafer described above.

In the film forming process, first, the SiC substrate 2 placed on the susceptor 50 is disposed in the chamber 10. After the chamber 10 is evacuated, the SiC epitaxial layer 3 is formed on the SiC substrate 2.

The SiC epitaxial layer 3 is formed while rotating the SiC substrate 2. A rotating direction of the SiC substrate 2 is set, for example, such that the notch 4 rotates clockwise. The rotating direction of the SiC substrate 2 may be opposite to this rotating direction.

The SiC epitaxial layer 3 is formed by supplying a mixed gas containing a Si-based source gas, a C-based source gas, an etching gas, a carrier gas and a dopant gas on one surface of the SiC substrate 2.

In addition, during formation of the SiC epitaxial layer 3, the purge gas is supplied toward the back surface of the SiC substrate 2 via the slit SL1. The purge gas is, for example, Ar. A flow rate of the purge gas is, for example, 5 sccm or more and 50 sccm or less. By supplying the purge gas from the slit SL1, a variation in distribution of the source gas supplied to a right side and a left side of the notch 4 is reduced. As a result, it is possible to fabricate the SiC epitaxial wafer 1 according to the embodiment with small thickness variation on the right side and the left side of the notch 4.

Here, the method of manufacturing the SiC epitaxial wafer 1 according to the embodiment has been described using the film forming apparatus 100 shown in FIG. 4 as an example, but the film forming apparatus is not limited to this example. The shape of the film-forming apparatus is not important as long as it can supply the purge gas to a predetermined position on the back surface of the SiC substrate 2. For example, the furnace may be a horizontal furnace in which the gas supply port 12 is located to the side of the placing surface of the SiC substrate 2.

In the SiC epitaxial wafer 1 according to the embodiment, the thickness variation of the SiC epitaxial layer 3 on the right side and the left side of the notch 4 is small, and the thickness uniformity of the SiC epitaxial layer 3 near the notch 4 is high. The notch 4 is used to control the position and orientation when fabricating the SiC device. When the thickness uniformity near the notch 4 is low, it may cause problems when reading the notch 4 with a laser or the like. The SiC epitaxial wafer 1 according to the embodiment has a high uniformity in the thickness of the SiC epitaxial layer 3 near the notch 4, allowing for precise control of position and orientation, thereby reducing defects when fabricating the SiC device.

Hereinabove, although the preferred embodiment of the present invention has been described in detail, the present invention is not limited to a specific embodiment, and various modifications and alterations are possible within the scope of the spirit of the present invention as set forth in the claims.

### [Examples]

### (Comparative Example 1)

In Comparative Example 1, a source gas flow distribution near a notch when depositing a SiC epitaxial wafer using a susceptor without a slit was measured by simulation. Since the susceptor has no slit, a sufficient amount of purge gas is not supplied toward a back surface of a SiC substrate. The simulation was performed using general-purpose fluid analysis software ANSYS Fluent. A diameter of the SiC substrate was 200 mm, a depth of the notch was 2 mm. A rotating direction of the SiC substrate was a direction in which the notch rotates clockwise. In addition, the simulation conditions were adiabatic at the furnace wall boundary.

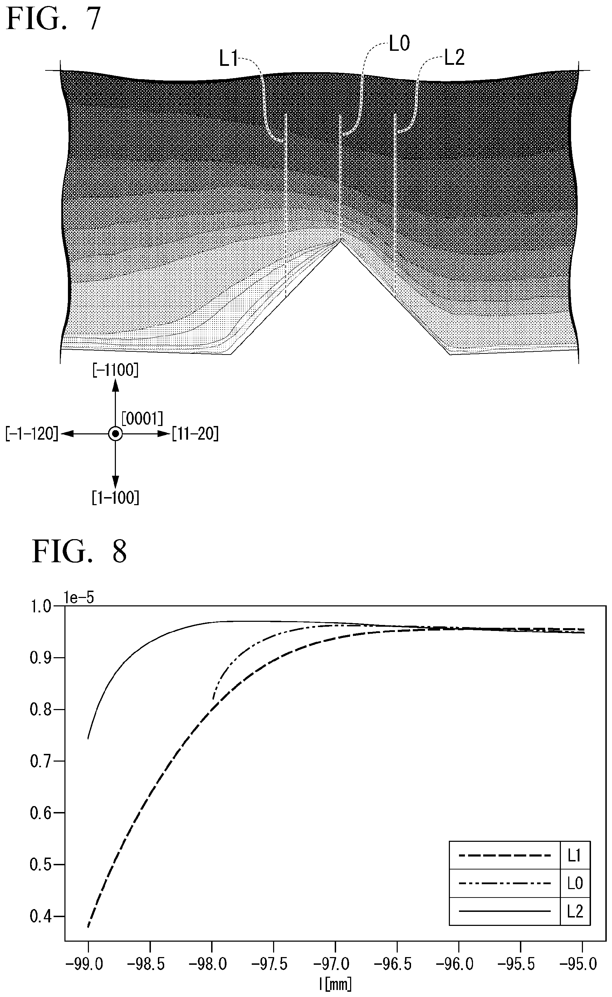

FIG. 7 shows simulation results of Comparative Example 1. In FIG. 7, the closer the color is to black, the greater the supply of raw material. The simulation results of Comparative Example 1 show that there is variation in the raw material supply amount between the right side and the left side of the notch.

FIG. 8 shows a supply amount of a source gas along each of the reference line L0, the first measurement line L1 and the second measurement line L2 in the simulation results of Comparative Example 1. A lateral axis of FIG. 8 shows a distance l from a reference axis that passes through the center of the SiC substrate and extending in the <11-20> direction. In the lateral axis of FIG. 8, the [-1100] direction is considered positive. Since the reference line L0 has the notch, the absolute value of the distance l from the reference axis is at most 98.0 mm. A vertical axis of FIG. 8 shows a supply amount of the source gas to the SiC substrate.

As shown in FIG. 8, it can be seen that there is a difference in the supply amount of the source gas between the left side of the notch (the first measurement line L1) and the right side of the notch (the second measurement line L2).

In addition, when an actual SiC epitaxial wafer was fabricated under the same conditions as Comparative Example 1, the film thickness of the SiC epitaxial layer at the measurement point of x = 500 µm (0.5 mm) on the first measurement line L1 was 3.36 µm, and the film thickness of the SiC epitaxial layer at the measurement point of x = 500 µm (0.5 mm) on the second measurement line L2 was 4.27 µm. The thickness variation of the SiC epitaxial layer of Comparative Example 1 was 11.9%.

### (Example 1)

Example 1 is distinguished from Comparative Example 1 in that a susceptor with the slit SL1 is used. The purge gas is supplied at 25 sccm from the slit SL1 toward the back surface of the SiC substrate. Other conditions were the same as in Comparative Example 1, and the supply amount of the source gas at the left side of the notch (the first measurement line L1) and the right side of the notch (the second measurement line L2) was simulated.

### (Comparative Example 2)

Comparative Example 2 is distinguished from Comparative Example 1 in that a susceptor with a slit SL2 is used. The purge gas is supplied at 25 sccm from the slit SL2 toward the back surface of the SiC substrate. The slit SL2 has the same shape as that of the slit SL1. The slit SL2 was located at a position that overlaps with the notch 4 when seen in a plan view. Other conditions were the same as in Comparative Example 1, and the supply amount of the source gas at the left side of the notch (the first measurement line L1) and the right side of the notch (the second measurement line L2) was simulated.

### (Comparative Example 3)

Comparative Example 3 is distinguished from Comparative Example 1 in that a susceptor with a slit SL3 is used. The purge gas is supplied at 25 sccm from the slit SL3 toward the back surface of the SiC substrate. The slit SL3 has the same shape as that of the slit SL1. The slit SL3 is located at a position shifted to the right side from the notch 4. One of corners of the slit SL3 is in the [1-100] direction from the innermost point 5 of the notch 4. Other conditions were the same as in Comparative Example 1, and the supply amount of the source gas at the left side of the notch (the first measurement line L1) and the right side of the notch (the second measurement line L2) was simulated.

### (Comparative Example 4)

Comparative Example 4 is distinguished from Comparative Example 1 in that a susceptor with a slit SL4 is used. The purge gas is supplied at 25 sccm from the slit SL4 toward the back surface of the SiC substrate. The slit SL4 has the same shape as that of the slit SL1. The slit SL4 is located at a position shifted to the left side from the notch 4. One of corners of the slit SL4 is in the [1-100] direction from the innermost point 5 of the notch 4. Other conditions were the same as in Comparative Example 1, and the supply amount of the source gas at the left side of the notch (the first measurement line L1) and the right side of the notch (the second measurement line L2) was simulated.

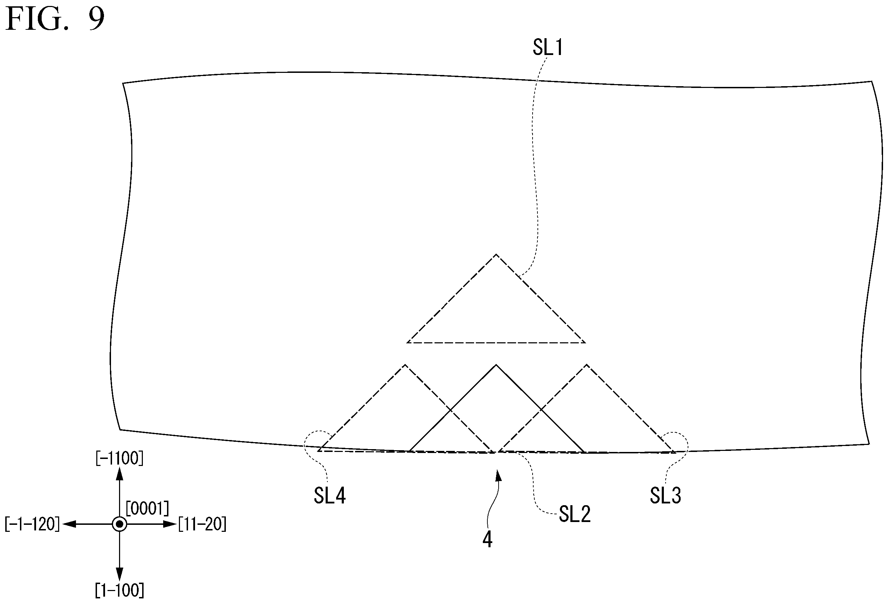

FIG. 9 is a view showing a positional relationship between the slits SL1 to SL4 in Example 1 and Comparative Examples 2 to 4.

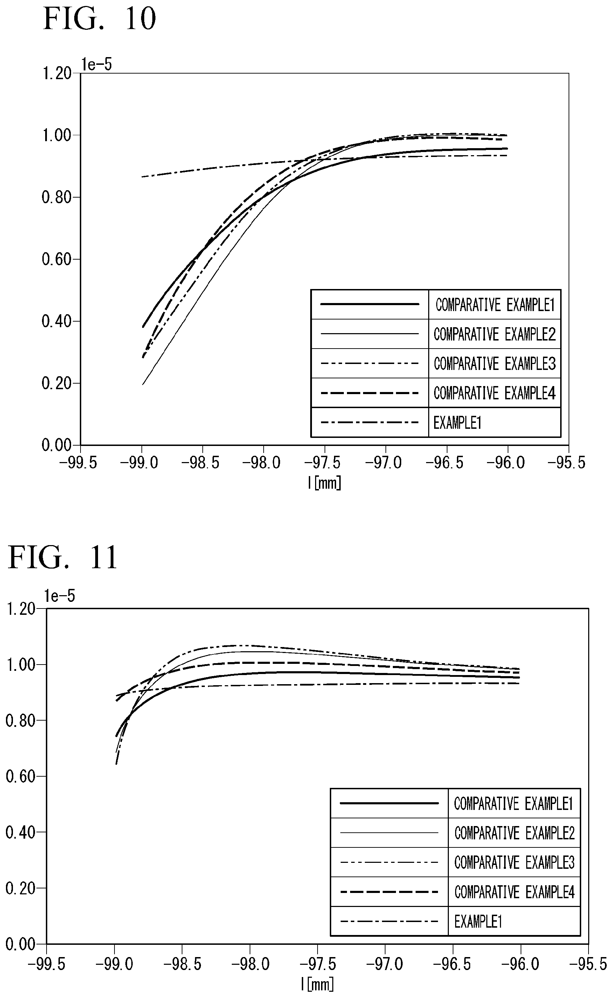

FIG. 10 shows a supply amount of the source gas along the first measurement line L1 in the simulation results of Example 1 and Comparative Examples 1 to 4. A lateral axis of FIG. 10 shows the distance l from the reference axis that passes through the center of the SiC substrate and extending in the <11-20> direction. In the lateral axis of FIG. 10, the [-1100] direction is considered positive. A vertical axis of FIG. 10 shows a supply amount of the source gas to the SiC substrate.

FIG. 11 shows a supply amount of the source gas along the second measurement line L2 in the simulation results of Example 1 and Comparative Examples 1 to 4. A lateral axis of FIG. 11 shows the distance l from the reference axis that passes through the center of the SiC substrate and extends in the <11-20> direction. In the lateral axis of FIG. 11, the [-1100] direction is considered positive. A vertical axis of FIG. 11 shows a supply amount of the source gas to the SiC substrate.

As shown in FIG. 10 and FIG. 11, Example 1 has smaller film thickness variation of the SiC epitaxial layer in the radial direction than Comparative Examples 1 to 4. In Comparative Examples 2 to 4, the purge gas was supplied toward the back surface of the SiC substrate as in Example 1, but the variation in the supply amount of the source gas was greater than in Comparative Example 1. In addition, as shown in FIG. 10 and FIG. 11, in Example 1, the difference in the supply amount of the source gas between the left side and the right side of the notch at the same distance l from the reference axis was smaller than in Comparative Examples 1 to 4.

When an actual SiC epitaxial wafer was fabricated under the same conditions as in Example 1, the film thickness of the SiC epitaxial layer at the measurement point of x = 500 µm (0.5 mm) on the first measurement line L1 was 9.63 µm, and the film thickness of the SiC epitaxial layer at the measurement point of x = 500 µm (0.5 mm) on the second measurement line L2 was 8.87 µm. The thickness variation of the SiC epitaxial layer of Example 1 was 4.10%.

### EXPLANATION OF REFERENCES

1 SiC epitaxial wafer
2 SiC substrate
3 SiC epitaxial layer
4 Notch
5, 5' Innermost point
6 First measurement point
7 Second measurement point
10 Chamber
11 Main body
12 Gas supply port
13 Gas discharge port
20 Support body
30 Lower heater
40 Upper heater
50 Susceptor
51 Main body
52 Frame
C1 First point
C2 Second point
L0 Reference line
L1 First measurement line
L2 Second measurement line
s1 First side
s2 Second side
SL1, SL2, SL3, SL4 Slit

## Claims

1. A SiC epitaxial wafer having:
a SiC substrate and a SiC epitaxial layer, and
a notch formed by cutting out a part of the wafer inward from an outer circumference when seen in a plan view in a lamination direction,
wherein the notch has a first side and a second side that connect the innermost point of the notch and an outer circumference of the wafer,
the first side is in a [-1-120] direction from the innermost point,
the second side is in a [11-20] direction from the innermost point,
when a position of 0.5 mm from a first point that is a middle point of the first side in a [-1100] direction is set as a first measurement point, and
a position of 0.5 mm from a second point that is a middle point of the second side in a [-1100] direction is set as a second measurement point,
a film thickness variation between a first film thickness of the SiC epitaxial layer at the first measurement point and a second film thickness of the SiC epitaxial layer at the second measurement point is less than 10%, and
the film thickness variation is calculated by dividing an absolute value of a difference between the first film thickness and the second film thickness by twice an average film thickness of the first film thickness and the second film thickness.

2. The SiC epitaxial wafer according to claim 1, wherein, when a film thickness of the SiC epitaxial layer at a position of x mm from the first point in the [-1100] direction is set as L(x),
a film thickness of the SiC epitaxial layer at a position of x mm from the second point in the [-1100] direction is set as R(x), and
an average value of L(x) and R(x) is set as Ave (L(x), R(x)),
|(L(x)-R(x))|/(2×Ave (L(x), R(x))) < 10% is satisfied in x≦5.

3. The SiC epitaxial wafer according to claim 1 or 2, wherein a diameter of the wafer is 145 mm or more.

4. The SiC epitaxial wafer according to claim 1 or 2, wherein a diameter of the wafer is 195 mm or more.

5. The SiC epitaxial wafer according to any one of claims 1 to 4, wherein the SiC epitaxial layer has a variation in film thickness in a radial direction of 5% or less, and
the variation in film thickness in the radial direction is calculated by dividing a difference between a maximum value and a minimum value of the film thickness of the SiC epitaxial layer measured along a straight line that passes through a center of the SiC epitaxial layer and extends in the <11-20> direction by twice the average value.

6. The SiC epitaxial wafer according to any one of claims 1 to 5, wherein the SiC epitaxial layer has a variation in film thickness in a circumferential direction of 5% or less, and
the variation in film thickness in the circumferential direction is calculated by dividing a difference between a maximum value and a minimum value of the film thickness of the SiC epitaxial layer measured at a total of four points of two points of half a radius from a center of the SiC epitaxial layer in the <11-20> direction and two points of half a radius from the center of the SiC epitaxial layer in the <-1-100> direction by twice the average value.
